Europäisches Patentamt

European Patent Office

Office européen des brevets

(11) Veröffentlichungsnummer: **0 017 899**
B1

# EUROPÄISCHE PATENTSCHRIFT

(45) Veröffentlichungstag der Patentschrift:
04.05.83

(21) Anmeldenummer: 80101876.3

(22) Anmeldetag: 08.04.80

(51) Int. Cl.³: **H 03 C 3/22,** H 03 B 5/12,
H 03 C 3/09, H 03 D 3/24

(54) **Steuerbare Oszillatoranordnung.**

(30) Priorität: 12.04.79 DE 2915134

(43) Veröffentlichungstag der Anmeldung:
29.10.80 Patentblatt 80/22

(45) Bekanntmachung des Hinweises auf die Patenterteilung:
04.05.83 Patentblatt 83/18

(84) Benannte Vertragsstaaten:
AT BE CH FR GB IT LI LU NL

(56) Entgegenhaltungen:
DE-B-1 303 540
FR-A-1 553 034
US-A-3 403 354

(73) Patentinhaber: SIEMENS AKTIENGESELLSCHAFT,
Berlin und München Wittelsbacherplatz 2,
D-8000 München 2 (DE)

(72) Erfinder: Heise, Rudolf, Winibaldstrasse 12,
D-8190 Wolfratshausen (DE)

## Steuerbare Oszillatoranordnung

Die Erfindung bezieht sich auf eine in ihrer Frequenz steuerbare Oszillatoranordnung, bestehend aus zwei Oszillator-Dreipunktschaltungen, deren Rückkopplung jeweils zwischen der dem eingangsseitigen und dem ausgangsseitigen Stromkreis gemeinsamen Elektrode und der Steuerelektrode der Verstärkerelementanordnung vorgenommen ist und deren Oszillatorausgang von der über eine niederohmige Impedanz mit Bezugspotential verbundenen Ausgangselektrode gebildet ist, bei der die beiden Oszillator-Dreipunktschaltungen zusammengeschaltet sind und hierbei der frequenzbestimmende Schwingkreis zwei gegensinnig geschaltete, über einen Steuereingang steuerbare Varaktordioden aufweist, die an ihren entgegengesetzten Anschlüssen mit jeweils einer der beiden Oszillator-Dreipunktschaltungen verbunden sind.

Eine Oszillatoranordnung dieser Art ist beispielsweise durch die DE-B-1 303 540 bekannt. Durch die Gegentaktanordnung wird hier zwar eine hohe Linearität der Frequenzänderung in Abhängigkeit der am Steuereingang wirksamen Steuerspannung erzielt, doch beträgt der Frequenzdurchstimmbereich nur wenige ‰ der Grundschwingungen der quarzstabilisierten Oszillator-Dreipunktschaltungen.

Die Verwendung gegensinnig geschalteter Varaktordioden ist auch durch die Literaturstelle NTZ, 1965, Heft 4, Seiten 186 bis 190 bekannt. Der lineare Aussteuerbereich der Frequenzvariation läßt sich zusätzlich dadurch optimieren, daß die Gesamtkapazität der beiden Varaktordioden möglichst wenig durch zusätzliche Kapazitäten geschert ist, also im wesentlichen das kapazitive Blindelement des frequenzbestimmenden Schwingkreises des Oszillators darstellt.

Werden hohe Anforderungen an die Linearität des Frequenzvariationsbereichs in Abhängigkeit einer Steuerspannung gestellt, so ist auch unter Berücksichtigung der geschilderten Linearisierungsmaßnahmen nur ein relativ kleiner linearer Frequenzvariationsbereich von etwa ±3% der generierten Grundschwingung erreichbar.

Wie die angeführte Literaturstelle NTZ ausweist, kann diesen Schwierigkeiten dadurch begegnet werden, daß von zwei Oszillatoren mit sehr hoch liegenden Schwingfrequenzen Gebrauch gemacht wird, die in ihren Schwingfrequenzen um den Betrag der gewünschten Zwischenfrequenz gegeneinander verschoben und zu dieser Zwischenfrequenz heruntergemischt werden. Wird einer dieser beiden Oszillatoren frequenzmoduliert, und zwar in den durch die Linearitätsanforderungen gegebenen Grenzen, dann läßt sich auf diese Weise die Modulationsbandbreite um den Betrag des Frequenzumsetzfaktors vergrößern.

Der Erfindung liegt die Aufgabe zugrunde, für eine frequenzmodulierbare Oszillatoranordnung eine weitere Lösung anzugeben, die unter Verzicht auf eine Frequenzumsetzung bei relativ geringem technischen Aufwand eine hohen Linearitätsanforderungen genügende breitbandige Frequenzvariation zuläßt.

Ausgehend von einer frequenzsteuerbaren Oszillatoranordnung mit zwei zu einer Gegentaktschaltung zusammengefügten Oszillator-Dreipunktschaltungen der einleitend beschriebenen Art wird die Aufgabe gemäß der Erfindung dadurch gelöst, daß die Ausgangsanschlüsse der Oszillator-Dreipunktschaltungen gleichstrommäßig über den Mittelabgriff der Primärwicklung eines gemeinsamen Ausgangsübertragers mit Bezugspotential in Verbindung stehen, daß ferner die beiden Varaktordioden, deren Kapazität weitgehend die Schwingkreiskapazität darstellt, gleichstrommäßig über die Schwingkreisinduktivität zusammengeschaltet sind und daß die Schwingkreisinduktivität zur Realisierung des Steuereingangs einen Mittelabgriff aufweist.

Der Erfindung liegt die Erkenntnis zugrunde, daß sich gerade durch eine Gegentaktschaltung mittels zweier Oszillator-Dreipunktschaltungen eine in ihrer Frequenz breitbandig linear modulierbare Oszillatoranordnung verwirklichen läßt, und zwar aus zwei Gründen. Einmal läßt sich hier der frequenzbestimmende Kreis so gestalten, daß die Kapazitäten der Varaktordioden nur in geringem Maße durch zusätzliche Serien- oder Parallelkondensatoren geschert werden, weil die bei den Oszillator-Dreipunktschaltungen zur Anwendung kommenden Koppelkondensatoren sehr groß gewählt werden können. Zum anderen wird hier durch das angewandte Gegentaktprinzip die Modulationssteuerquelle weitgehend von der generierten Grundschwingung entkoppelt. Hierzu kommt, daß bei der erfindungsgemäßen Anordnung das Modulationssteuersignal von der Modulationssteuerquelle mit niedrigem Innenwiderstand angeboten werden kann und somit gut geeignet ist für hohe Modulationsfrequenzen. Die Grenzfrequenz für den Aussteuerbereich ergibt sich nämlich hier aus dem Innenwiderstand der Modulationssteuerquelle mit der Kapazität von zwei parallel geschalteten Varaktordioden.

Bei einer bevorzugten Ausführungsform weist jede der beiden Oszillator-Dreipunktschaltungen einen Transistor auf, dessen Emitter wechselstrommäßig über einen ersten Koppelkondensator mit seiner Basis und über einen zweiten Koppelkondensator wechselstrommäßig mit Bezugspotential verbunden ist und dessen Basis weiterhin den Anschlußpunkt für eine Varaktordiode und den Abgriff eines Spannungsteilers für die Arbeitspunktspannung bildet.

In Weiterbildung der Erfindung ist der Mittelabgriff der Schwingkreisinduktivität über einen Saugkreis aus einer Serieninduktivität einem Serienkondensator und einem Serienwiderstand mit Bezugspotential verbunden, dem ein Widerstand parallel geschaltet ist. Dabei liegt die Resonanzfrequenz des Saugkreises oberhalb der zweifachen Mittenfrequenz des Variationsbereiches des frequenzbestimmenden Schwingkreises und der den Innenwiderstand der Steuerspannungsquelle umfassende Widerstand weist wenigstens den fünffach kleineren Wert des Wellenwiderstandes des Saugkreises auf. Auf diese Weise läßt sich die hochlineare Aussteuerung der Frequenz der Oszillatoranordnung von ±5% der generierten Grundschwingung auf ±8% erweitern. Dieses hervorragende Ergebnis wird unter anderem dadurch möglich, daß hier die Kompensation nichtlinearer Effekte über die erste Oberwelle herbeigeführt wird, die innerhalb der Gegentaktschaltung weitgehend von der Grundwelle entkoppelt ist.

Weitere vorteilhafte Ausgestaltungen der Erfindung sind in den Ansprüchen 3 und 4 angegeben.

Anhand eines in der Zeichnung dargestellten Ausführungsbeispieles soll die Erfindung im folgenden noch näher erläutert werden. In der Zeichnung bedeuten

Fig. 1 das Grundschema eines von einem frequenzsteuerbaren Oszillator Gebrauch machenden Frequenzmodulators,

Fig. 2 das Grundschema eines von einem frequenzsteuerbaren Oszillator Gebrauch machenden Frequenzdemodulators,

Fig. 3 ein frequenzsteuerbarer, in den Schaltungen nach Fig. 1 und 2 anwendbarer Oszillator nach der Erfindung.

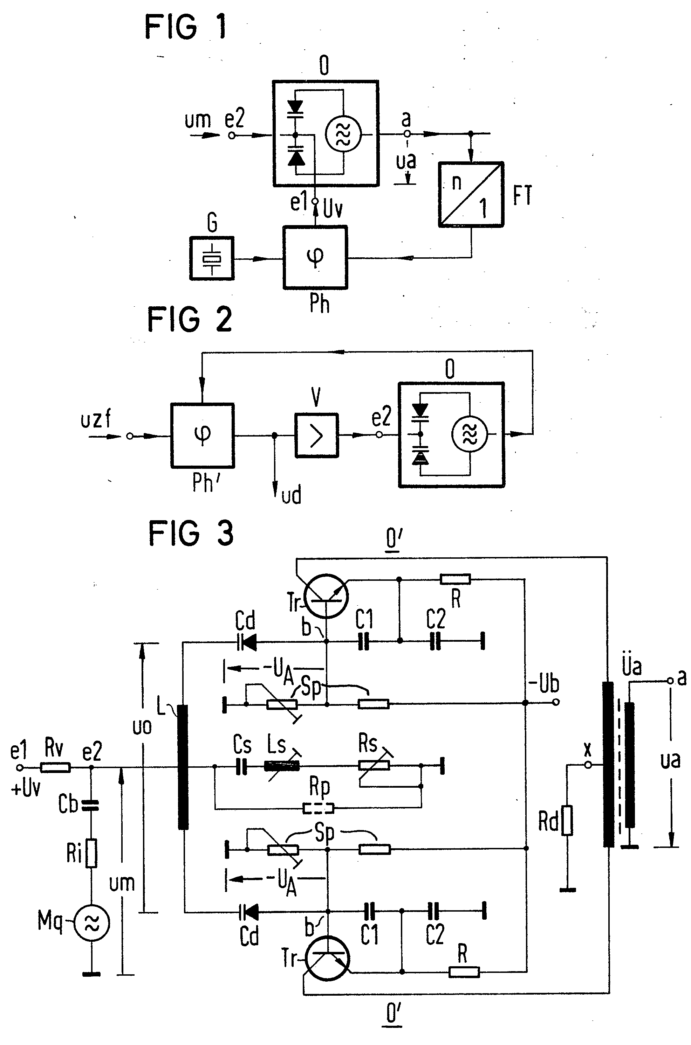

Wie Fig. 1 erkennen läßt, weist der frequenzsteuerbare Oszillator O mit gegensinnig geschalteten Varaktordioden zwei Steuereingänge e1 und e2 auf. Über den Steuereingang e1 ist die Regelspannung Uv wirksam, die eine relativ große Zeitkonstante aufweist und die generierte Grundschwingung mit Hilfe einer Phasenregelschleife an eine Bezugsschwingung anbindet, die hier der Quarzgenerator G erzeugt. Die Regelschleife selbst weist den Frequenzteiler FT und den Phasenvergleicher Ph auf. Mit Hilfe des Frequenzteilers FT wird die Oszillatorschwingung mit der Spannung ua am Ausgang a des Oszillators O in ihrer Frequenz um den Faktor n auf die Frequenz des Quarzgenerators G heruntergeteilt und mit der Bezugsschwingung im Phasenvergleicher Ph verglichen. Das Vergleichsergebnis wird in Form der bereits erwähnten Regelspannung Uv am frequenzbestimmenden Kreis des Oszillators O wirksam. Über den Eingang e2 wird dem Oszillator die eigentliche Modulationsspannung um zugeführt. Die Modulationsspannung um steuert ebenfalls die gegensinnig geschalteten Varaktordioden gleichsinnig aus.

Wie Fig. 2 zeigt, kann ein solcher steuerbarer Oszillator O auch für Demodulationszwecke verwendet werden. In Fig. 2 wird der frequenzsteuerbare Oszillator O jeweils auf die Frequenz des ankommenden zu demodulierenden Zwischenfrequenzsignals uzf über eine Regelschleife hingezogen. Zu diesem Zweck wird das Ausgangsignal des Oszillators O am Ausgang a dem ersten Eingang des Phasenvergleichers Ph zugeführt, an dessen zweiten Eingang das zu demodulierende Signal uzf ansteht. Die aus dem Vergleich resultierende Regelspannung am Ausgang des Phasenvergleichers Ph stellt hier das demodulierte Signal ud dar. Dieses Signal wird über den Verstärker V dem Eingang e2 des Oszillators O zugeführt. Im Gegensatz zu der Phasenregelschleife des Modulators nach Fig. 1 ist die zur Demodulation benutzte Phasenregelschleife so ausgelegt, daß sie der Änderung des zu demodulierenden ankommenden Zwischenfrequenzsignals uzf folgen kann.

Die erfindungsgemäße frequenzsteuerbare Oszillatorschaltung, wie sie in den Schaltungen nach den Fig. 1 und 2 Verwendung finden kann, ist in Fig. 3 dargestellt. Sie besteht aus zwei im Gegentakt geschalteten Oszillator-Dreipunktschaltungen O'. Jede dieser Dreipunktschaltungen besteht aus dem Transistor Tr, dessen Emitter über den Koppelkondensator C1 mit der Basis und über den Koppelkondensator C2 mit Bezugspotential verbunden ist. Die negative Betriebsgleichspannung −Ub wird den Emittern der Transistoren Tr über den Widerstand R und deren Basis am Anschlußpunkt b über einen Abgriff der Spannungsteiler SP zugeführt. Der den Oszillator-Dreipunktschaltungen gemeinsame frequenzbestimmende Schwingkreis besteht aus der Schwingkreisinduktivität L, über die die beiden Varaktordioden Cd gegensinnig zusammengeschaltet sind. Der Steuereingang e2 liegt am Mittelabgriff der Schwingkreisinduktivität L. Die Varaktordioden Cd sind mit ihrem zweiten Anschluß mit dem Anschlußpunkt b verbunden. Die Koppelkondensatoren C1 und C2 haben gegenüber der Kapazität der Varaktordioden Cd einen sehr hohen Wert, so daß die Varaktorkapazitäten praktisch das kapazitive Blindelement des frequenzbestimmenden Schwingkreises darstellen. Der Ausgang des frequenzsteuerbaren Oszillators nach Fig. 3 wird von dem Ausgangsübertrager Üa gebildet, an dessen Sekundärwicklung vom Anschluß a gegen Bezugspotential die Ausgangsspannung ua abgenommen wird. Die Anschlüsse der Primärwicklung des Ausgangsübertragers Üa sind mit den Kollektoranschlüssen der Transistoren Tr verbunden. Der Mittelabgriff x der Primärwicklung ist über den Widerstand Rd mit Bezugspotential verbunden. Die dem Steuereingang e2 zugeführte Modulationsspannung um wird von der Modulationsquelle Mq mit dem Innenwiderstand Ri erzeugt und über den Koppelkondensator Cb dem Steuereingang e2 zugeführt. Der Steuereingang e1 ist dadurch verwirklicht, daß zwischen ihm und dem Steuereingang e2 der Vorwiderstand Rv vorgesehen ist. Vom Mittelabgriff der Schwingkreisinduktivität L liegt ferner gegen Bezugspotential ein Saugkreis, bestehend aus dem Serienkondensator Cs der Serieninduktivität Ls und dem einstellbaren Serienwiderstand Rs. Ferner ist dem Saugkreis der Widerstand Rp parallel geschaltet, der den Innenwiderstand Ri der Modulationsquelle Mq mit umfaßt.

Durch das bei der Schaltung nach Fig. 3 zur Anwendung kommende Gegentaktprinzip, ist die Grundschwingung, die am Ausgang a in Form der Ausgangsspannung ua auftritt, weitgehend von der ersten Oberwelle entkoppelt. Durch die Entkopplung der Transistoren Tr mittels der Koppelkondensatoren C1 und C2 wird die Kreisgüte des frequenzbestimmenden Schwingkreises im wesentlichen durch die Güte der Kapazitätsdioden bestimmt. Durch die große Anschwingsteilheit dieses Schaltungsprinzips kann die Schwingamplitude in vorteilhafter Weise so herabgesetzt werden, daß die hochfrequente Diodendurchsteuerung klein gehalten wird. Ohne den in Fig. 3 dargestellten Saugkreis läßt sich bei einer solchen Schaltung mit einer Oszillatormittenfrequenz von 70 MHz eine lineare Steilheitskurve (bei einer Steilheitsverzerrung $\leq 0,5\%$) von $\pm 5\%$ entsprechend einer Trägerabweichung von $\pm 3,5$ MHz erzielen.

In Weiterbildung der Erfindung läßt sich der erfindungsgemäße Gegentaktoszillator mit Hilfe seiner Oberwelleneigenschaften im linearen Steilheitsbereich durch den bereits erwähnten Saugkreis erweitern. Der Saugkreis ist hierbei auf eine Resonanzfrequenz oberhalb der zweifachen Oszillatormittenfrequenz der Grundschwingung abgestimmt und bewirkt in Verbindung mit dem ihm parallel geschalteten Widerstand Rp, der hierbei wenigstens gleich dem fünffachen kleineren Wert des Wellenwiderstandes des Saugkreises bemessen ist, eine in Richtung auf seine Resonanz abnehmende kapazitive Blindkomponente. Diese Eigenschaft wirkt sich über die Verkopplung der Ströme der Grundwelle und der Oberwelle im Sinne der gewünschten Vergrößerung der linearen Steilheitskurve aus. Von großem Vorteil ist in diesem Zusammenhang, daß der Saugkreis von der Grundwelle entkoppelt ist, weil vom Mittelabgriff der Schwingkreisinduktivität L gegen Bezugspotential aufgrund des Gegentaktprinzips lediglich Oberwellenströme fließen.

Durch Hinzuschalten weiterer Saugkreise (abstimmbar auf den Bereich > der zweifachen Oszillator-Mittenfrequenz bzw. < der zweifachen Oszillator-Mittenfrequenz) kann die Steilheitskurve sowohl in ihrem linken als auch in ihrem rechten Kennlinienteil (bezogen auf die Mittenfrequenz) noch weiter linearisiert werden, so daß dadurch der Oszillator zur Modulation mit noch höherer Basisbandfrequenz brauchbar wird.

Bezogen auf das erwähnte Ausführungsbeispiel bei einer Oszillatormittenfrequenz von 70 MHz und einer zulässigen Steilheitsverzerrung $\leq 0,5\%$ ergibt sich bei Anwendung des geschilderten Saugkreises eine lineare Steilheitskurve von $\pm 8\%$ entsprechend einer Trägerabweichung von $\pm 5,6$ MHz.

Der dem Saugkreis parallel geschaltete Widerstand Rp kann praktisch frei gewählt werden, wenn die Modulationsquelle Mq für einen vernachlässigbar kleinen Innenwiderstand ausgelegt wird, was wegen der hier möglichen niederohmigen Ansteuerung grundsätzlich möglich ist.

Wie Fig. 3 ferner zeigt, sind die Spannungsteiler Sp einstellbar ausgeführt. Hierdurch läßt sich der durch die Kollektor-Emitterspannung gegebene Arbeitspunkt der Transistoren Tr so einstellen, daß bei wirksamer AM-Begrenzung trotzdem keine Zunahme des Oberwellengehalts auftritt.

## Patentansprüche

1. In ihrer Frequenz steuerbare Oszillatoranordnung (O), bestehend aus zwei Oszillator-Dreipunktschaltungen (O'), deren Rückkopplung jeweils zwischen der dem eingangsseitigen und dem ausgangsseitigen Stromkreis gemeinsamen Elektrode und der Steuerelektrode der Verstärkerelementanordnung (Tr) vorgenommen ist und deren Oszillatorausgang von der über eine niederohmige Impedanz (Rd) mit Bezugspotential verbundenen Ausgangselektrode gebildet ist, bei der die beiden Oszillator-Dreipunktschaltungen (O') zusammengeschaltet sind und hierbei der frequenzbestimmende Schwingkreis (L, Cd) zwei gegensinnig geschaltete, über einen Steuereingang (e1, e2) steuerbare Varaktordioden (Cd) aufweist, die an ihren entgegengesetzten Anschlüssen mit jeweils einer der beiden Oszillator-Dreipunktschaltungen verbunden sind, dadurch gekennzeichnet, daß die Ausgangsanschlüsse der Oszillator-Dreipunktschaltungen (O') gleichstrommäßig über den Mittelabgriff (x) der Primärwicklung eines gemeinsamen Ausgangsübertragers (Üa) mit Bezugspotential in Verbindung stehen, daß ferner die beiden Varaktordioden (Cd), deren Kapazität weitgehend die Schwingkreiskapazität darstellt, gleichstrommäßig über die Schwingkreisinduktivität (L) zusammengeschaltet sind und daß die Schwingkreisinduktivität (L) zur Realisierung des Steuereingangs (e2) einen Mittelabgriff aufweist.

2. Oszillatoranordnung nach Anspruch 1, dadurch gekennzeichnet, daß jeder der beiden Oszillator-Dreipunktschaltungen (O') einen Transistor (Tr) aufweist, dessen Emitter wechselstrommäßig über einen ersten Koppelkondensator (C1) mit seiner Basis und über einen zweiten Koppelkondensator (C2) wechselstrommäßig mit Bezugspotential verbunden ist und dessen Basis weiterhin den Anschlußpunkt (b) für eine Varaktordiode (Cd) und den Abgriff eines Spannungsteilers (Sp) für die Arbeitspunktspannung ($U_A$) bildet.

3. Oszillatoranordnung nach Anspruch 2, dadurch gekennzeichnet, daß der Spannungsteiler (Sp) einstellbar ausgeführt und die Arbeitspunktspannung für eine Begrenzung der generierten Schwingung festgelegt ist.

4. Oszillatoranordnung nach einem der vorhergehenden Ansprüche, dadurch gekennzeichnet, daß der Mittelabgriff (x) der Primärwicklung des Ausgangsübertragers (Üa) über einen eine Gleichtakterregung unterdrückenden Widerstand (Rd) mit Bezugspotential verbunden ist.

5. Oszillatoranordnung nach einem der vorhergehenden Ansprüche, dadurch gekennzeichnet, daß der Mittelabgriff der Schwingkreisinduktivität (L) über einen Saugkreis aus einer Serieninduktivität (Ls) einem Serienkondensator (Cs) und einem Serienwiderstand (Rs) mit Bezugspotential verbunden ist, dem ein Widerstand (Rp) parallel geschaltet ist, daß ferner die Resonanzfrequenz des Saugkreises oberhalb der zweifachen Mittenfrequenz des Variationsbereiches des frequenzbestimmenden Schwingkreises liegt und daß der den Innenwiderstand (Ri) der Steuerspannungsquelle umfassende Widerstand (Rp) wenigstens den fünffach kleineren Wert des Wellenwiderstandes des Saugkreises aufweist.

6. Oszillatoranordnung nach Anspruch 5, dadurch gekennzeichnet, daß dem Saugkreis (Ls, Cs) weitere Saugkreise parallel geschaltet sind, deren Resonanzfrequenz auf Werte oberhalb und/oder unterhalb der zweifachen Oszillator-Mittenfrequenz abgestimmt sind.

**Claims**

1. An oscillator arrangement (O) controllable in respect of its frequency and which consists of two oscillator three-terminal networks (O') whose back coupling is respectively effected between that electrode common to the input and to the output and the control electrode of the amplifier element arrangement (Tr), and whose oscillator output is formed by the output electrode connected via a low-ohmic impedance (Rd) to the reference potential, and wherein the two oscillator three-terminal networks (O') are interconnected and the oscillation circuit (L, Cd) determining the frequency possesses two oppositely switched varactor diodes (Cd) which can be controlled by means of a control input (e1, e2) and which are respectively connected to one of the two oscillator three-terminal networks at their opposite terminals, characterised in that the output terminals of the oscillator three-terminal networks (O') are connected to the reference potential in respect of d.c. by means of the centre tap (c) of the primary winding of a common output transformer (Üa), that furthermore the two varactor diodes (Cd), whose capacitance largely represents the capacitance of the oscillation circuit, are interconnected in respect of d.c. by means of the oscillation circuit inductance (L), and that the oscillation circuit inductance (L) possesses a centre tap in order to realise the control input (e2).

2. An oscillator arrangement as claimed in Claim 1, characterised in that each of the two oscillator three-terminal networks (O') has a transistor (Tr) whose emitter is connected via a first coupling capacitor (Cl) to its base in respect of a.c. and connected via a second coupling capacitor (C2) to the reference potential in respect of a.c. and whose base further forms the terminal point (b) for a varactor diode (Cd) and the tap of a voltage divider (Sp) for the operating point voltage ($U_A$).

3. An oscillator arrangement as claimed in Claim 1, characterised in that the voltage divider (Sp) is designed so as to be adjustable and the operating point voltage for a limitation of the generated oscillation is determined.

4. An oscillator arrangement as claimed in one of the preceding Claims, characterised in that the centre tap (x) of the primary winding of the output transformer (Üa) is connected to the reference potential by means of a resistance (Rd) suppressing an in-phase excitation.

5. An oscillator arrangement as claimed in one of the preceding Claims, characterised in that by means of a tank circuit consisting of a series inductance (Ls), a series capacitor (Cs) and a series resistance (Rs), the centre tap of the oscillation circuit inductance (L) is connected to the reference potential to which a resistance (Rp) is connected in parallel, that furthermore the resonance frequency of the tank circuit lies above the doubled centre frequency of the variation region of the oscillation circuit determining the frequency, and that the resistance (Rp) comprising the internal resistance (Ri) of the control voltage source has a value at least five times smaller than the value of the surge resistance of the tank circuit.

6. Oscillator arrangement as claimed in Claim 5, characterised in that further tank circuits, whose resonance frequency is tuned to values above and/or below the doubled oscillator centre frequency, are connected in parallel to the tank circuit (Ls, Cs).

**Revendications**

1. Dispositif oscillateur (O), dont la fréquence peut être commandée et qui est constitué par deux montages oscillateurs Hartley (O'), dont la réaction est réalisée respectivement entre l'électrode commune au circuit situé du côté entrée et au circuit situé du côté sortie, de l'électrode de commande de l'élément de circuit amplificateur (Tr), et dont la sortie de l'oscillateur est formée par l'électrode de sortie portée au potentiel de référence par l'intermédiaire d'une impédance de faible valeur ohmique (Rd), dans lequel les deux montages oscillateurs Hartley (O) sont interconnectés et le circuit oscillant (L, Cd) déterminant la fréquence comporte deux diodes Varactor (Cd) montées en opposition et pouvant être commandées par l'intermédiaire d'une entrée de commande (e1, e2) et qui sont reliées, par leurs bornes opposées, chacune à l'un des deux montages oscillateurs Hartley, caractérisé en ce que les bornes de sortie des montages oscillateurs Hartley (O) sont reliées, du point de vue du courant continu, par l'intermédiaire de la prise médiane (x) de l'enroulement primaire d'un transformateur de sortie commun (Üa), au potentiel de référence, qu'en outre les deux diodes Varactor (Cd), dont la capacité représente dans une large mesure la capacité du circuit oscillant, sont interconnectées, du point de vue du courant continu, par l'intermédiaire de l'inductance (L) du circuit oscillant et que l'inductance (L) du circuit oscillant comporte, pour la réalisation de l'entrée de commande (e2), une prise médiane.

2. Dispositif oscillateur selon la revendication 1, caractérisé en ce que chacun des deux montages oscillateurs Hartley (O') comporte un transistor (Tr), dont l'émetteur est relié, du point de vue du courant alternatif, par l'intermédiaire d'un premier condensateur de couplage (C1), à sa base et, du point de vue du courant alternatif, par l'intermédiaire d'un second condensateur de couplage (C2), au potentiel de référence, et dont la base forme en outre le point de raccordement (b) pour une diode Varactor (Cd) et la prise d'un diviseur de tension (Sp) pour la tension (U$_A$) du point de fonctionnement.

3. Dispositif oscillateur selon la revendication 2, caractérisé en ce que le diviseur de tension (Sp) est réalisé de manière à être réglable et que la tension du point de fonctionnement est fixée pour une limitation de l'oscillation produite.

4. Dispositif oscillateur selon l'une des revendications précédentes, caractérisé en ce que la prise médiane (x) de l'enroulement primaire du transformateur de sortie (Üa) est reliée, par l'intermédiaire d'une résistance (Rd) supprimant l'excitation en mode commun, au potentiel de référence.

5. Dispositif oscillateur selon l'une des revendications précédentes, caractérisé en ce que la prise médiane de l'inductance (L) du circuit oscilant est reliée au potentiel de référence par l'intermédiaire d'un circuit piège constitué d'une inductance série (Ls), d'un condensateur série (Cs) et d'une résistance série (Rs) et sur lequel est branchée en parallèle une résistance (Rp), qu'en outre la fréquence de résonance du circuit piège est supérieure au double de la fréquence centrale de la plage de variation du circuit oscillant déterminant la fréquence et que la résistance (Rp) incluant la résistance interne (Ri) de la source de tension de commande, est égale au moins au cinquième de la valeur de l'impédance caractéristique du circuit absorbant.

6. Dispositif oscillateur selon la revendication 5, caractérisé en ce qu'en parallèle sur le circuit piège (Ls, Cs) sont branchés d'autres circuits piège, dont la fréquence de résonance est accordée sur des valeurs supérieures et/ou inférieures au double de la fréquence centrale de l'oscillateur.

# FIG 1

# FIG 2

# FIG 3